# EUROPÄISCHE PATENTSCHRIFT

(11) **EP 0 594 652 B1**
(45) Veröffentlichungstag und Bekanntmachung des Hinweises auf die Patenterteilung: **08.11.1995**
(21) Anmeldenummer: 92913719.8
(22) Anmeldetag: 27.06.1992
(51) Int. Cl.: H05K 13/02, B23Q 35/10, B23Q 5/34, H01L 21/00

(54) **WERKZEUGMASCHINE MIT KURVENGETRIEBE, INSBESONDERE ZUM STANZEN UND FORMEN DER ANSCHLUSSBEINCHEN VON INTEGRIERTEN SCHALTKREISEN**
MACHINE TOOL WITH CURVED DRIVE, ESPECIALLY FOR STAMPING AND SHAPING THE CONNECTING PINS OF INTEGRATED CIRCUITS
MACHINE-OUTIL AVEC COMMANDE A CAMES, EN PARTICULIER POUR L'ESTAMPAGE ET LE FORMAGE DES PATTES DE CONNEXION DE CIRCUITS INTEGRES

(30) Priorität: 16.07.1991 DE 4123512
(43) Veröffentlichungstag der Anmeldung: 04.05.1994
(73) Patentinhaber: MICRON TECHNOLOGY, INC., Boise, ID 83706-9698 (US)
(72) Erfinder: HINTERLECHNER, Gerhard, D-75180 Pforzheim (DE); GÄBEL, Ulrich, Hans, D-75305 Neuenbürg (DE)
(74) Vertreter: Twelmeier, Ulrich, Dipl.Phys.
(86) Internationale Anmeldenummer: EP9201450
(87) Internationale Veröffentlichungsnummer: WO9302540

(56) Entgegenhaltungen:
- EP-A- 0 226 136
- DE-A- 3 103 525

## Beschreibung

Die Erfindung geht aus von einer Werkzeugmaschine mit Kurvengetriebe, insbesondere zum Stanzen und Formen der Anschlußbeinchen von integrierten Schaltkreisen mit den im Oberbegriff des Anspruchs 1 angegebenen Merkmalen.

### Stand der Technik

Eine solche Maschine ist aus der DE-PS 35 44 087 und DE-A-3 103 525 bekannt. In der bekannten Maschine werden die Werkzeuge durch ein Kurvengetriebe angetrieben, welches zwei gleichachsig angeordnete, angetriebene Kurvenscheiben hat. An der als Kurvenbahn ausgebildeten Stirnfläche jeder der beiden Kurvenscheiben liegt eine frei drehbare Rolle an. Jede der beiden Rollen ist am Ende eines zweiarmigen Hebels gelagert, welcher die von der sich drehenden Kurvenbahn bewirkte Auslenkung der Rolle auf eine Werkzeughälfte bzw. auf eine Halterung dafür überträgt, welche am gegenüberliegenden Ende des Hebels angeordnet ist. Die beiden Hebel sind durch eine Zugstrebe miteinander verbunden, an deren Enden die beiden Hebel schwenkbar gelagert sind.

Damit die Rollen stets im Kontakt mit den Kurvenscheiben bleiben, werden sie durch Kraftschluss an die durch deren Stirnseite gebildete Kurvenbahn gedrückt oder gezogen, und zwar im allgemeinen durch Federn. Die durch die Federn aufgebrachten Vorspannkräfte müssen größer sein als die beim Beschleunigen und Abbremsen der Werkzeuge auftretenden Kräfte, um ein Abheben der Rollen von den Kurvenscheiben zu vermeiden. Nachteilig dabei ist, dass diese Vorspannkräfte umgekehrt den Antrieb erschweren, weil sie beim Antreiben der Werkzeuge überwunden werden müssen, so dass man einen entsprechend kräftigen, schweren Antriebsmotor benötigt. Ein weiterer Nachteil ergibt sich daraus, dass das vom Antriebsmotor aufzubringende Drehmoment für den eigentlichen von den Werkzeugen durchgeführten Bearbeitungsvorgang um das Drehmoment erhöht wird, welches benötigt wird, um die auf die Rollen einwirkenden Vorspannkräfte zu überwinden; dadurch muss die Ansprechschwelle einer im Antriebsstrang vorgesehenen Überlastkupplung in unerwünschter Weise angehoben werden, welche die Werkzeuge im Überlastfall vor Schaden bewahren soll. Ein weiterer Nachteil besteht darin, dass eine Einrichtung zur Vorspannung der Rollen durch Federn eine an sich erwünschte Verschiebung der Hebel parallel zur Antriebsachse der Kurvenscheiben behindert; eine solche Verschiebbarkeit ist zur Anpassung der Werkzeugmaschine an unterschiedliche Bearbeitungsaufgaben erwünscht.

Zur Vermeidung der Vorspannkräfte ist es bekannt, die Rolle nicht auf der Stirnseite, sondern in einer Nut der Kurvenscheibe (Nutkurvengetriebe) oder ein Rollenpaar beidseits einer Wulst der Kurvenscheibe (Wulstkurvengetriebe) zu führen. Bei gleichen Abtastverhältnissen wie bei einem Kurvengetriebe, bei dem die Rolle aussen auf der Stirnseite der Kurvenscheibe läuft, haben Nutkurvenscheiben und Wulstkurvenscheiben aber einen größeren Durchmesser, so dass im Kurvengetriebe größere Massenträgheitsmomente auftreten, was unerwünscht ist, weil dadurch entweder die Maschine nur langsamer angehalten werden kann oder die Antriebskräfte und Bremskräfte größer werden und der Verschleiß zunimmt. Die Beschleunigungs- und Bremskräfte der Werkzeughälften und der sie tragenden Aufspanneinrichtungen treten im wesentlichen in Richtung der Werkzeugbewegung auf. Sie sind von Nachteil insbesondere bei einer schnellen Beschleunigungsumkehr, weil die in der Richtung der Werkzeugbewegung auftretenden, von den Werkzeugen und Getriebegliedern ausgehenden Massenträgheitskräfte das Maschinengestell und die Werkstückaufnahme zu Schwingungen anregen, teils mit hoher Anregungsfrequenz. Um der Schwingungsanregung entgegenzuwirken, ist es bekannt, den Scheitelpunkt der Beschleunigungsumkehr in Richtung der Anfahrbeschleunigung zu verschieben, so dass die Bremsverzögerung verkleinert wird, allerdings mit dem Nachteil einer Vergrößerung der Anfahrbeschleunigung.

In der DE-PS 35 44 087 findet sich ferner ein Hinweis, dass die Rückstellung der Werkzeuge über Nocken oder Kurvenscheiben gesteuert werden kann, aber ohne eine konkrete Angabe, wie das zu geschehen hat und ob das einen Einfluß auf das Schwingungsverhalten hat.

Die erwähnten Nachteile sind besonders gravierend bei Maschinen zum Stanzen und Formen der Anschlußbeinchen von integrierten Schaltkreisen, denn einerseits müssen diese Arbeiten mit hoher Genauigkeit durchgeführt werden, vor allem bei Schaltkreisen, die wegen einer hohen Integrationsdichte viele Beinchen haben, zum anderen ist für eine preiswerte Fertigung ein rascher Arbeitstakt erwünscht, dem jedoch Massenträgheit, die Neigung zu Schwingungen und eine Verschleißerhöhung entgegenstehen. Die Neigung zu Schwingungen ist besonders gravierend, denn nur, wenn die integrierten Schaltkreise ruhig liegen und die Werkzeuge nicht vibrieren, können die Stanz- und Formarbeiten an den grazilen Anschlußbeinchen mit der gewünschten Präzision durchgeführt werden und kann eine Steuerung und Überwachung der Werkzeugmaschine mittels einer Kamera für Bilderkennungs- und Bildvermessungseinrichtungen erfolgen. Zum Vibrieren neigen die ICs, die zunächst mit ihren Anschlußbeinchen noch in vorgestanzten Metallbändern (sogenannten Leadframes) hängen, wenn die Beinchen in einem Arbeitsschritt vom Leadframe abgetrennt sind und die ICs dann nur noch an vier dünnen Stegen im Leadframe hängend weiter bearbeitet werden.

### Darstellung der Erfindung

Der vorliegenden Erfindung liegt die Aufgabe zugrunde, den Werkzeugantrieb in einer Werkzeugmaschine der eingangs genannten Art, insbesondere in einer Maschine zum Stanzen und Formen der Anschlußbeinchen von integrierten Schaltkreisen, so zu gestalten, dass er bei geringen Massenträgheitsmomenten mit geringeren Antriebsmomenten und Bremsmomenten auskommt und gleichzeitig die Neigung zur Anregung von Schwingungen der Werkstückaufnahme (Aufspannplatte) und des Gestells vermindert wird.

Diese Aufgabe wird gelöst durch eine Werkzeugmaschine mit den im Anspruch 1 angegebenen Merkmalen. Vorteilhafte Weiterbildungen der Erfindung sind Gegenstand der abhängigen Ansprüche.

Bei der erfindungsgemässen Maschine laufen die Rollen der beiden Hebel jeweils auf einer Kurvenbahn aussen auf der Stirnseite von wenigstens einer Kurvenscheibe, doch wird der Kontakt zwischen Kurvenbahn und Rolle nicht durch mechanische Vorspannung mittels einer Feder sichergestellt, sondern dadurch, dass jeder Kurvenbahn eine zweite, starr mit ihr verbundene Kurvenbahn zugeordnet ist, deren Kurvenprofil dem der ersten Kurvenbahn komplementär ist, und dass jeder der beiden Hebel an seinem einen Schenkel nicht nur eine, sondern zwei frei drehbare Rollen trägt, die in Umfangsrichtung der Kurvenbahn gegeneinander versetzt sind, und zwar vorzugsweise bezogen auf die Achse der Kurvenbahnen, in 90°-Stellung zueinander, und von denen die eine Rolle auf der einen Kurvenbahn und die andere auf der zweiten, dazu komplementären Kurvenbahn abrollt, welche gegenüber der ersten Kurvenbahn einen entsprechenden Versatz aufweist. Durch die komplementäre Ausbildung der Kurvenbahnen kann ohne Vorspannkräfte erzwungen werden, dass die beiden Rollen eines Hebels steten Kontakt mit ihrem Kurvenbahnpaar haben. Der Vorteil dieser Anordnung liegt darin, dass man bei vorgegebenem Abtastverhältnis mit den kleinst möglichen Kurvenscheiben auskommt und insoweit ein niedriges Massenträgheitsmoment gegeben ist, wobei durch die Vermeidung von Vorspannfedern zugleich die Antriebsmomente klein gehalten werden können. Entsprechend klein ist die Amplitude von Schwingungen, zu denen die Maschine angeregt werden kann.

Die zweiten Rollen befinden sich mit ihren Achsen nahe bei einer durch die Achse der Kurvenbahnen gehenden Senkrechten auf der Bewegungsrichtung Z der Werkzeughälften, vorzugsweise auf dieser Senkrechten. Die Verwendung der zwei in der gewählten Anordnung gegeneinander versetzten Rollen für jeden Hebel hatden großen Vorteil, dass die beim Beschleunigen und Abbremsen auftretenden Kräfte nicht mehr ausschließlich parallel zur Bewegungsrichtung des Werkzeuges in das Maschinengestell eingeleitet, sondern in zwei Richtungen aufgeteilt werden. Die für das Anregen von Schwingungen besonders kritischen Beschleunigungskräfte bei der Rückholbewegung (Leerhub) der Werkzeuge und die Bremskräfte beim Arbeitshub werden erfindungsgemäss in eine quer zur Werkzeugbewegung verlaufende Richtung umgelenkt. Die Anfahrbeschleunigung beim Arbeitshub und die Bremsverzögerung beim Leerhub treten hingegen in Richtung der Werkzeugbewegung auf. Durch die Aufteilung der Kräfte in unterschiedliche Richtungen werden die Neigung zur Schwingungsanregung und die Anregungsfrequenz vermindert, und zwar insbesondere in dem bevorzugten Fall, dass die Führungseinrichtung für die Werkzeuge, welche vorzugsweise eine Platte oder ein Block ist, bzw. eine sie tragende Aufspannplatte, waagerecht verläuft und mithin auch die Werkzeugbewegung waagerecht erfolgt und die beiden ersten Rollen der beiden Hebel dementsprechend in eine zur Führungseinrichtung bzw. zur Werkzeugaufspannplatte parallelen Ebene unter dieser gelagert sind; in diesem Fall leiten die zweiten Rollen der Hebel einen wesentlichen Teil der Kräfte nach unten in das Gestell und in das Maschinenfundament ein, so dass während der Beschleunigungsphase im Leerhub und während der Bremsphase im Arbeitshub an den Lagern der beiden Hebel eine schräg zur Werkzeugbewegung gerichtete resultierende Kraft in das Gestell eingeleitet wird. Der Teil der Kräfte, der nach unten in das Gestell und in das Fundament eingeleitet wird, führt wegen der Masse des Gestells und des Fundaments zu weniger Anregung von Schwingungen der Maschine. Die Maschine zeichnet sich deshalb durch einen sehr ruhigen Lauf aus, was bei den hohen Genauigkeitsanforderungen in der Mikromechanik ein bedeutender Vorteil ist. Darüberhinaus ist ein ruhiger Lauf eine Voraussetzung für eine höhere Arbeitsgeschwindigkeit. Zugleich bedeutet ein ruhiger Lauf geringeren Verschleiß und erlaubt den Einsatz einer Kamera für Bilderkennung und Bildvermessung.

Das unbewegliche Teil des Kurvengetriebes, an dem die Hebel gelagert sind, ist zweckmäßigerweise eine Zugstrebe. Vorzugsweise wird die Zugstrebe durch die Aufspannplatte für die Werkzeuge selbst gebildet. Das hat den Vorteil, dass die Aufspannplatte nur auf Zug beansprucht wird. Sie wird deshalb beim Preß- und Druckvorgang nicht verformt, sondern im Gegenteil durch die Zugkräfte sogar gestreckt. Das kommt einer präzisen Lagerung der zu bearbeitenden Werkstücke und einer präzisen Führung der Werkzeuge sehr entgegen, was bei mikromechanischen Bearbeitungen, wie sie an mikroelektronischen Bauteilen nötig sind, ein wesentlicher Vorteil ist.

Dass man die Hebel nahe bei den Werkzeugen, vorzugsweise unmittelbar an der Aufspannplatte anlenkt, hat den weiteren Vorteil, dass damit ein kompakter Aufbau der Werkzeug- und Getriebeanordnung optimal möglich ist, der weiterhin dadurch gefördert wird, dass erfindungsgemäss die zweiten Rollen eines jeden Hebels nahe bei den Werkzeugen, vorzugsweise dicht unter der Aufspannplatte oder sogar in einer Ausnehmung der Aufspannplatte angeordnet werden. Dadurch werden die Hebel sehr kurz und trägheitsarm.

Nach einem weiteren bevorzugten Merkmal der Erfindung ist die zweite Rolle eines jeden Hebels, welche in der unmittelbaren Nachbarschaft der Werkzeuge bzw. der Aufspannplatte liegt, kleiner als die erste Rolle. Das ist möglich, weil sie nicht die höheren Bearbeitungskräfte übertragen muss, denn diese werden von den beiden anderen, einander diametral gegenüberliegenden ersten Rollen übertragen.

Weil die zweiten Rollen kleiner sein können, wird nochmals ein dichteres Heranrücken der Kurvenbahnen an die Aufspannplatte möglich, verbunden mit einer entsprechenden Verkürzung der beiden Hebel, was sich wiederum günstig in einer Verkleinerung der Massenträgheit auswirkt. Die geringe Massenträgheit in Kombination mit dem Antrieb über komplementäre Kurvenbahnen hat zur Folge, dass man zur Beschleunigung mit einem kleinen Antriebsmoment auskommt, welches unterhalb der reinen Bearbeitungsmomente liegt, so dass es möglich ist, im Antriebsstrang des Kurvengetriebes eine Überlastkupplung mit entsprechend niedriger Ansprechschwelle vorzusehen. Ausserdem verkleinert jede Verkleinerung der Antriebsmomente die Kräfte, die zur Anregung von Schwingungen führen können.

Für ein schwingungsarmes, präzises Arbeiten der Werkzeuge ist auch eine spielfreie Kopplung der Hebel, welche die Werkzeuge betätigen, mit den Kurvenbahnen von Bedeutung. Hier bewährt sich einmal mehr der Antrieb der Werkzeuge über komplementäre Kurvenbahnen, die von je zwei in Umfangsrichtung gegeneinander versetzten Rollen am einen Schenkel eines zweischenkligen Hebels abgetastet werden. Ein besonders geringes Spiel in der Kopplung der Hebel mit den Kurvenbahnen erreicht man nämlich bei einer Weiterbildung der Erfindung, gemäss welcher der die Rollen tragende Schenkel der Hebel in einen Hauptschenkel, der die erste Rolle trägt, und einen demgegenüber schwächeren Nebenschenkel verzweigt ist, der die zweite Rolle trägt. Der Nebenschenkel kann schwach ausgebildet sein, weil er nur die für das Rückholen der Werkzeuge (Leerhub) benötigten Kräfte übertragen können muss, und diese Kräfte sind sehr viel geringer als die Kräfte, die der Hauptschenkel beim Arbeitshub übertragen muss. Während der Hauptschenkel gemessen an den auftretenden Kräften starr sein muss, kann der Nebenschenkel demgegenüber so schwach sein, dass er, wenn die Rollen den Kurvenbahnen mit etwas Druck angelegt werden, elastisch gebogen wird. Auf diese Weise erreicht man, dass die Rollen unter Ausnutzung des Zurückfederns des schwachen Nebenschenkels den Kurvenbahnen absolut spielfrei anliegen, wenn die Lage der Schwenkachse des Hebels in Bezug auf die Kurvenscheiben so gewählt ist, dass die Rollen ständig mit leichtem Andruck den Kurvenbahnen anliegen. Solange die Rollen den Kurvenbahnen spielfrei anliegen, kann es zu einer zusätzlichen Schwingungsanregung durch ein Kurvenspiel nicht kommen, und das ist umso länger gewährleistet, je schwächer der Nebenschenkel des Hebels ist, denn je schwächer der Nebenschenkel ist, desto größer ist der Federweg bei der federnden Anlage der Rolle des Nebenschenkels und desto länger dauert es, bis der Hebel nachgestellt werden oder ausgetauscht werden muss, um Kurvenspiel zu vermeiden.

Die Verwendung von Kurvenscheiben, die aussen abgetastet werden, ermöglicht eine weitere vorteilhafte Weiterbildung der Erfindung, die darin besteht, dass wenigstens die ersten Rollen, die die Kräfte beim Arbeitshub übertragen, vorzugsweise auch die zweiten Rollen, die die Kräfte beim Leerhub übertragen, nicht nur einseitig, sondern beidseitig in ihrem Hebel gelagert sind. Dadurch wird die Anordnung aus Hebel und Rollen besonders steif und dadurch die Betätigung der Werkzeuge und die von ihnen ausgeführte Bearbeitung besonders präzise.

In vorteilhafter Weiterbildung der Erfindung sind die Hebel in Lagerböcken gelagert, welche parallel zur Achse der Kurvenbahnen vorzugsweise längs der Aufspannplatte verschiebbar sind. Dadurch sind die Werkzeugstationen bequem längs der Aufspannplatte verstellbar; die Kurvenscheiben sind natürlich entsprechend längs der Welle, auf der sie befestigt sind, verschiebbar. Die Hebel können mit ihren Lagerböcken zur Auf- und Abrüstung senkrecht zu ihrer seitlichen Aufspannfläche an der Werkzeugaufspannplatte entnommen werden.

Die Kurvenbahn und Komplementärkurvenbahn, die von dem einen Hebel abgetastet werden, und die Kurvenbahn und Komplementärkurvenbahn, die von dem anderen Hebel abgetastet werden, sind vorzugsweise gleichachsig angeordnet, könnten aber auch auf zwei getrennten, zueinander parallelen Achsen angeordnet sein und werden synchron angetrieben.

Der Erfindungsgedanke kann auch übertragen werden auf Werkzeugmaschinen, in denen eine bewegliche Werkzeughälfte (Stempel) gegen eine feststehende Werkzeughälfte (Matrize) arbeitet, so dass nur ein Hebel und ein Paar aus Kurvenbahn und Komplementärkurvenbahn benötigt wird. Eine solche Maschine ist Gegenstand des unabhängigen Anspruchs 2.

### Wege zur Ausführung der Erfindung

Zur weiteren Erläuterung der Erfindung dienen die beigefügten Zeichnungen.
- Figur 1: zeigt schematisch die Anordnung eines Kurvengetriebes und einer Werkzeugaufspannplatte mit Werkzeugaufspanneinrichtungen in einer Werkzeugmaschine mit Blickrichtung in Richtung der Antriebswelle des Kurvengetriebes,

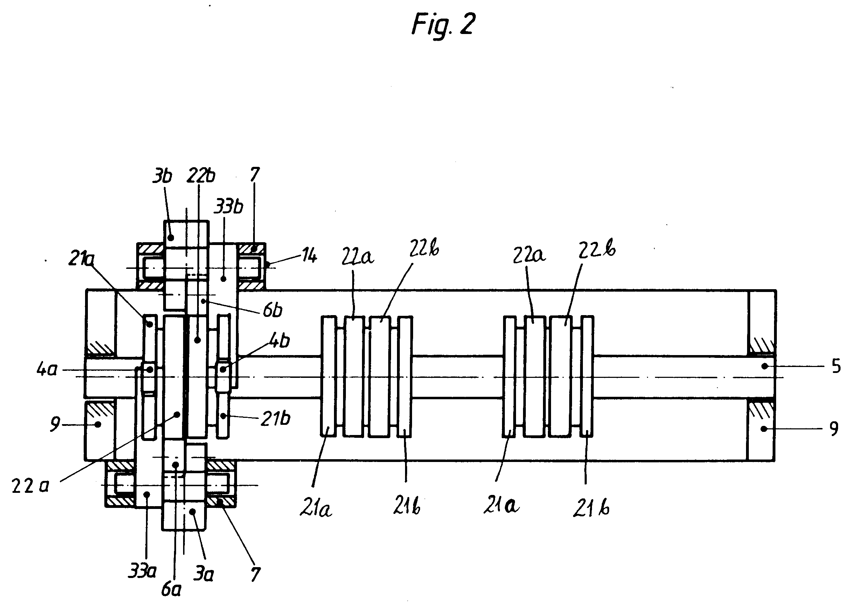

- Figur 2: zeigt schematisch und teilweise im Schnitt die Draufsicht auf die Anordnung gemäss Figur 1 bei entfernter Aufspannplatte,
- Figur 3: zeigt ein Beschleunigungsdiagramm,
- Figur 4: zeigt eine Anordnung wie in Figur 1, aber mit geänderter Gestalt der Hebel, und
- Figur 5: zeigt als Detail die zweiseitige Lagerung einer Rolle in ihrem Hebel.

Auf einem Maschinengestell 10 ist das Gehäuse 11 eines Kurvengetriebes angebracht, welches nach oben hin durch eine waagerechte Aufspannplatte 8 verschlossen ist. Auf der Aufspannplatte 8 werden die Bearbeitungswerkzeuge aufgespannt. Die Werkzeuge bestehen aus zwei gegeneinander arbeitenden Werkzeughälften 12 und 13, welche von der Werkzeugführung 1 in waagerechter Richtung Z gegenläufig und zueinander geführt werden. Um sie hin und her zu bewegen wirken zwei zweiarmige Hebel 3a und 3b auf sie ein, welche um waagerechte Achsen 14 schwenkbar in Lagerböcken 7 gelagert sind, welche durch eine Nut-und-Feder-Verbindung 15 mit der Aufspannplatte 8 verbunden und in deren Längsrichtung verschiebbar sind. Der obere Schenkel 23a bzw. 23b des jeweiligen Hebels ist mit den Werkzeughälften 13 bzw. 12 verbunden. Der untere Schenkel 33a bzw. 33b des jeweiligen Hebels verzweigt sich in zwei Abschnitte, welche an ihrem Ende jeweils eine erste größere Rolle 6a bzw. 6b und eine kleinere Rolle 4a bzw. 4b tragen, die Kurvenbahnen anliegen, die an der Stirnseite von Kurvenscheiben ausgebildet sind. Die Kurvenscheiben sind auf einer gemeinsamen Welle 5 in der Mitte unter der Aufspannplatte 8 befestigt. Die Rolle 6a liegt einer Kurvenscheibe 22a, die Rolle 6b einer Kurvenscheibe 22b, die Rolle 4a einer Kurvenscheibe 21a und die Rolle 4b einer Kurvenscheibe 21b an. Diese vier Kurvenscheiben könnten auch durch eine einzige Scheibe ersetzt werden, auf deren Stirnseite vier Kurvenbahnen ausgebildet sind. Die Rollen 4a und 4b befinden sich unmittelbar unterhalb der Aufspannplatte 8 und ragen teilweise in eine Ausnehmung 18 der Aufspannplatte hinein; sie befinden sich ausserdem in Bezug auf die Welle 5 in etwa in 90°-Stellung zu den Rollen 6a und 6b, welche einander diametral gegenüberliegend etwa in Höhe der Welle 5 angeordnet sind. Die Kurvenbahn der Kurvenscheibe 21a ist komplementär zur Kurvenbahn der Kurvenscheibe 22a und gegenüber dieser in Umfangsrichtung um ca. 90° versetzt. Entsprechend hat die Kurvenscheibe 21b eine Kurvenbahn, welche komplementär zur Kurvenbahn der Kurvenscheibe 22b und dieser gegenüber in Umfangsrichtung um ca. 90° versetzt ist. Durch die gewählte Art der Anordnung sind die Rollen 4a und 4b sowie 6a und 6b praktisch spielfrei auf den Kurvenscheiben 21a, 21b, 22a und 22b geführt und die Hebel 3a und 3b sind optimal kurz.

Um in der Werkzeugmaschine mehrere Bearbeitungen gleichzeitig durchführen zu können, sind drei Werkzeugpositionen vorgesehen; bei anderen Ausführungsbeispielen können auch mehr als drei Werkzeugpositionen vorgesehen sein; dementsprechend befinden sich auf der in den Gehäusewänden 9 gelagerten Welle 5 drei Gruppen von Kurvenscheiben, welche vorzugsweise auf der Welle 5 verschiebbar sind.

Die Hebel 3a und 3b sind baugleich ausgeführt und einander symmetrisch gegenüberliegend angeordnet. Die beiden Rollen 4a und 6a bzw. 4b und 6b eines jeden Hebels 3a bzw. 3b stellen im Zusammenspiel mit der Lagerung des Hebels um dessen Achse 14 eine formschlüssige Verbindung mit dem jeweiligen Kurvenscheibenpaar 21a und 22a bzw. 21b und 22b her.

Um ein niedriges Massenträgheitsmoment und damit kleine Massenträgheitskräfte der Hebel 3a und 3b bei der Beschleunigung zu erreichen, sind die Hebel so kurz wie möglich, die unteren Schenkel 33a und 33b der beiden Hebel möglichst dicht unter der Aufspannplatte 8 angeordnet und die Rollen 4a und 4b klein ausgebildet, jedenfalls kleiner als die Rollen 6a und 6b, welche die Bearbeitungskräfte übertragen müssen. Die kleinen Rollen 4a und 4b werden nur durch die bei der Beschleunigung auftretenden Massenträgheitskräfte des Hebels 3a bzw. 3b und der reduzierten Masse des bewegten Teils des daran hängenden Werkzeuges belastet. Durch die Anordnung der Rollen 4a und 4b senkrecht über der Welle 5 werden die von ihnen aufgenommenen Beschleunigungskräfte, welche vom Kurvenanstiegswinkel abhängen, im wesentlichen senkrecht in das Maschinengestell und weiter in den Boden eingeleitet. Wegen der dabei beteiligten großen Gestellmasse und der guten Fußdämpfung der Massen wird die Beschleunigungsamplitude stark verkleinert und die Maschine wird deshalb nicht mehr so stark zu Schwingungen angeregt, sondern läuft sehr viel ruhiger, was einerseits zu geringerem Verschleiß führt, andererseits aber auch zu höherer Präzision beim Arbeiten, weil die Werkstücke und die Werkzeuge ruhiger liegen. Die Abstützung der Bearbeitungskräfte in den Werkzeugen übernehmen die Rollen 6a und 6b über die dicht benachbarten Kurvenscheiben 22a und 22b, welche breiter sind als die komplementären Kurvenscheiben 21a und 21b. Hinsichtlich der Bearbeitungskräfte liegt ein geschlossener Kraftfluß vom Werkstück über die Werkzeughälfte 12, den Hebel 3a, die Rolle 6a, die Kurvenscheiben 22a und 22b, die Rolle 6b, den Hebel 3b und die Werkzeughälfte 13 zurück zum Werkstück vor. Die Aufspannplatte 8 wird dabei über die Drehachsen 14 der Hebel nur auf Zug belastet und unterliegt keiner Verformung.

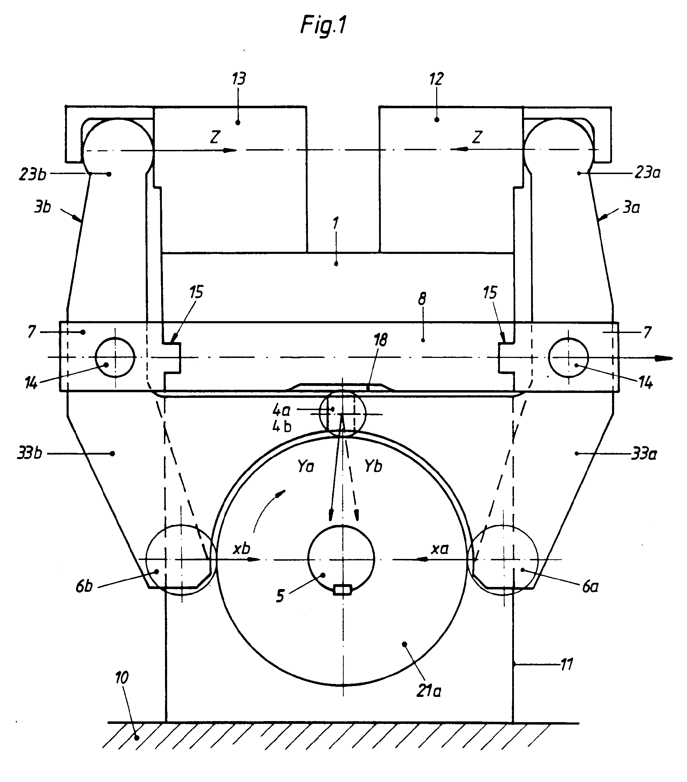

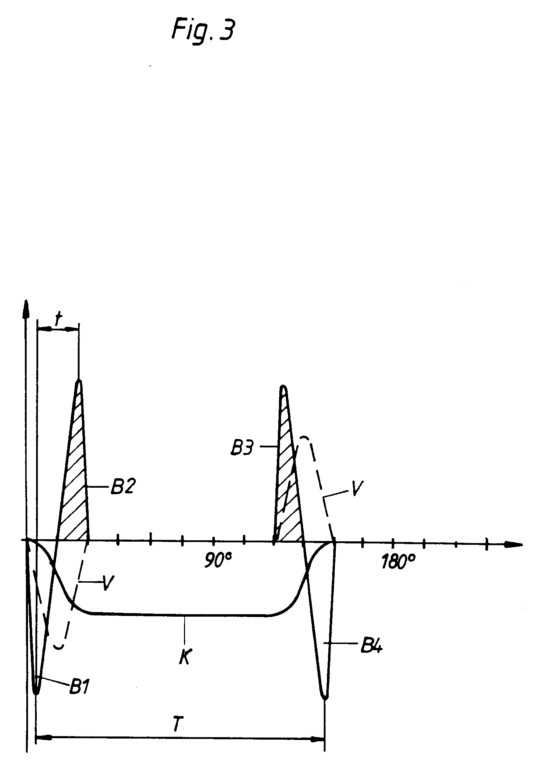

Figur 3 zeigt schematisch am Beispiel eines sich über einen Umfangswinkel von 150° erstreckenden Kurvenverlaufs K den zeitlichen Verlauf der Geschwindigkeit V und der Beschleunigung B an einem Hebel zwischen Kurvenscheibe und Werkzeug. Beim Einfahren einer Werkzeughälfte in Richtung Z auf ein Werkstück erfährt die große Rolle 6a bzw. 6b eine Beschleunigung B1, jedoch übernimmt das Abbremsen der Einfahrbewegung die kleine Rolle 4a bzw. 4b und erfährt dabei die Verzögerung B2. Umgekehrt wird bei der Rückzugsbewegung des Werkzeugs zunächst die kleinere Rolle 4a bzw. 4b belastet und erfährt die Beschleunigung B3, wohingegen das Abbremsen der Rückzugsbewegung über die größere Rolle 6a bzw. 6b erfolgt und diese dabei die Verzögerung B4 erfährt. Da die kleine Rolle 4a bzw. 4b die Beschleunigungskräfte annähernd senkrecht nach unten (Richtung Ya bzw. Yb in Figur 1) über das Gestell 10 in den Boden einleitet und damit praktisch unschädlich macht, kommen für eine Schwingungsanregung in der Ebene der Aufspannplatte 8 nur noch die Massenbeschleunigungskräfte in Betracht, die von den großen Rollen 6a und 6b übertragen werden. Die Zeitbasis für die Schwingungsanregung ist gegeben durch den zeitlichen Abstand der Maxima von B1 und B4. Würden jedoch wie im Stand der Technik die kleineren Rollen 4a und 4b fehlen, müssten die von ihnen aufgenommenen Beschleunigungskräfte ebenfalls von den Rollen 6a bzw. 6b aufgenommen und übertragen werden; sie würden dann ebenfalls zur Schwingungsanregung in der Ebene der Aufspannplatte 8 beitragen, und zwar mit einer Zeitbasis entsprechend dem Abstand der Maxima von B1 und B2 bzw. von B3 und B4, welcher sehr viel kleiner ist als der Abstand der Maxima von B1 und B4, so dass die Anregungsfrequenzen erfindungsgemäss um ein Mehrfaches unter den Anregungsfrequenzen beim Stand der Technik liegen, was sehr erwünscht ist.

Es sei noch darauf hingewiesen, dass man anhand der Figur 1 anschaulich sieht, dass bei der gewählten Anordnung der kleinen Rollen 4a und 4b in der Mitte über den Kurvenscheiben und dicht unter der Aufspannplatte 8 leicht ein seitliches Herausnehmen der Hebel 3a und 3b senkrecht zur Aufspannfläche der Lagerböcke 7 möglich ist, wodurch eine gute Zugangsmöglichkeit zum Kurvengetriebe und dessen Verstellung gewährleistet wird.

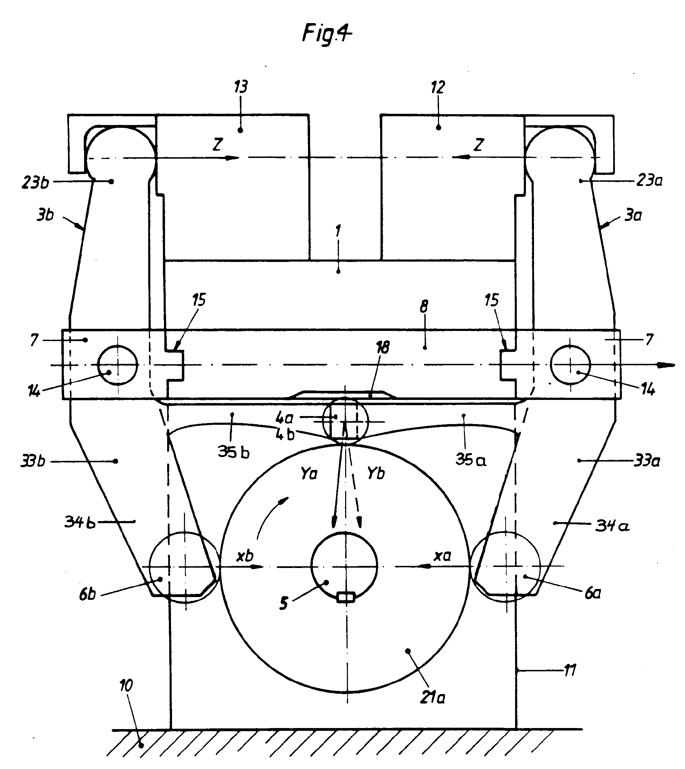

Das Ausführungsbeispiel in Figur 4 unterscheidet sich von dem in Figur 1 darin, dass die Schenkel 33a und 33b der Hebel 3a und 3b in einen kräftigen Hauptschenkel 34a bzw. 34b und in einen demgegenüber wesentlich schwächeren Nebenschenkel 35a bzw. 35b verzweigt sind. Der Hauptschenkel 34a bzw. 34b trägt jeweils die erste Rolle 6a bzw. 6b zur Übertragung der Kräfte beim Arbeitshub. Der Nebenschenkel 35a bzw. 35b trägt jeweils die kleinere Rolle 4a bzw. 4b zur Übertragung der Kräfte beim Leerhub. Weil der Nebenschenkel sehr viel schwächer ist als der Hauptschenkel, kann der Nebenschenkel 35a bzw. 36a etwas zurückfedern, wenn man die beiden Rollen 6a und 4a bzw. 6b und 4b mit etwas Druck auf ihren Kurvenscheiben laufen läßt. Durch die geringe federnde Auslenkung des Nebenschenkels, welche die Antriebsmomente nicht wesentlich erhöht, wird eine absolut spielfreie Kopplung zwischen den Kurvenscheiben 21a, 21b, 22a, 22b und den Rollen 6a, 6b, 4a, 4b, erreicht.

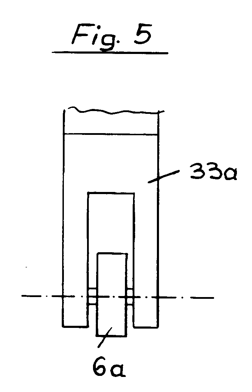

Wie Figur 5 zeigt, ist der Hauptschenkel 34a bzw. 34b zweckmässigerweise gabelförmig ausgebildet und die Rolle 6a bzw. 6b darin beidseitig gelagert, so dass die Anordnung aus Hebel 3a bzw. 3b und Rolle 6a bzw. 6b recht steif ist.

Im Ausführungsbeispiel gemäss Figur 1 oder Figur 4 kann eine der Werkzeughälften, z.B. die Werkzeughälfte 13, stationär sein. Dann entfallen die Hebel 3b und die zugehörigen Kurvenscheiben 21b und 22b . Auch diese Maschine hat einen ruhigeren Lauf, wenn auch die Welle 5 stärker einseitig belastet wird.

### Gewerbliche Anwendbarkeit

Die Erfindung ist besonders geeignet für Werkzeugmaschinen zum Stanzen und Formen der Anschlußbeinchen von integrierten Schaltkreisen, welche der Werkzeugmaschine in einem metallischen Trägerband (Leadframe) hängend zugeführt werden.

## Patentansprüche

1. Werkzeugmaschine mit Werkzeugen zum Ausführen von Stanz-, Schnitt-, Präge- und Formarbeiten, insbesondere zum Stanzen und Formen der Anschlußbeinchen von integrierten Schaltkreisen (ICs),
mit einem Gestell (10),
mit einem auf dem Gestell (10) gelagerten Kurvengetriebe zum Antreiben der Werkzeuge längs einer Führungseinrichtung (1), mit zwei auf parallelen Achsen angeordneten antreibenden Kurvenbahnen auf der Stirnseite von einer oder mehreren Kurvenscheiben (21a, 21b, 22a, 22b),
mit zwei an einem unbewegten Teil (8) des Kurvengetriebes schwenkbar gelagerten zweischenkligen Hebeln (3a, 3b), die an ihrem ersten Schenkel (23a, 23b) mit jeweils einer von gegeneinander arbeitenden Werkzeughälften (12, 13) verbunden sind und an ihrem zweiten Schenkel (33a, 33b) jeweils eine frei drehbare Rolle (6a, 6b) tragen, von denen die eine (6a) an der einen antreibenden Kurvenbahn (auf 22a) und die andere (6b) an der anderen antreibenden Kurvenbahn anliegt und beide Rollen (6a,6b) ungefähr diametral in bezug auf die Achse der antreibenden Kurvenbahnen (22a, 22b) und ungefähr parallel zur Werkzeugbewegungsrichtung (Z) angeordnet sind, und mit weiteren auf der Stirnseite der Kurvenscheibe(n) angeordneten Kurvenbahnen zur Steuerung der Werkzeugrückstellung,
**dadurch gekennzeichnet,**
dass jeder antreibenden Kurvenbahn eine der weiteren Kurvenbahnen zugeordnet und starr mit ihr verbunden ist und dass die weiteren Kurvenbahnen zu der ihnen zugeordneten antreibenden Kurvenbahn (auf 22a, 22b) ein komplementäres Kurvenprofil haben und in Umfangsrichtung versetzt sind,
dass die beiden Hebel (3a, 3b) an ihrem zweiten Schenkel (33a, 33b) jeweils noch eine zweite, frei drehbare Rolle (4a, 4b) tragen, welche der weiteren Kurvenbahn anliegt,
und dass sich die zweiten Rollen (4a, 4b) mit ihren Achsen nahe bei einer durch die Achse der Kurvenbahnen (auf 21a, 21b; 22a, 22b) gehenden Senkrechten auf der Bewegungsrichtung Z der Werkzeughälften (12, 13) nahe bei letzteren befinden.

2. Werkzeugmaschine mit Werkzeugen zum Ausführen von Stanz-, Schnitt-, Präge- und/oder Formarbeiten, insbesondere zum Stanzen und Formen der Anschlußbeinchen von integrierten Schaltkreisen (ICs),
mit einem Gestell (10),
mit einem auf dem Gestell (10) gelagerten Kurvengetriebe zum Antreiben der Werkzeuge längs einer Führungseinrichtung (1), mit einer antreibender Kurvenbahn auf der Stirnseite einer Kurvenscheibe (21a, 21b, 22a, 22b),
mit einem an einem unbewegten Teil (8) des Kurvengetriebes schwenkbar gelagerten zweischenkligen Hebel (3a bzw. 3b), der an seinem ersten Schenkel (23a bzw. 23b) mit einer gegen eine zweite Werkzeughälfte arbeitenden beweglichen Werkzeughälfte (12) bzw. 13) verbunden ist und an seinem zweiten Schenkel (33a, bzw. 33b) eine frei drehbare Rolle (6a bzw. 6b) trägt, welche an der antreibenden Kurvenbahn anliegt, und mit einer auf der Stirnseite der Kurvenscheibe angeordneten weiteren Kurvenbahn zur Steuerung der Werkzeugrückstellung,
**dadurch gekennzeichnet,**
dass der antreibenden Kurvenbahn die weitere Kurvenbahn zugeordnet und starr mit ihr verbunden ist und dass die weitere Kurvenbahn zu der ihr zugeordneten antreibenden Kurvenbahn ein komplementäres Kurvenprofil hat und in Umfangsrichtung versetzt ist,
dass der Hebel (3a bzw. 3b) an seinem zweiten Schenkel (33a, 33b) noch eine zweite, frei drehbare Rolle (4a bzw. 4b) trägt, welche der weiteren Kurvenbahn anliegt,
und dass sich die zweite Rolle (4a bzw. 4b) mit ihrer Achse nahe bei einer durch die Achse der Kurvenbahnen gehenden Senkrechten auf der Bewegungsrichtung Z der Werkzeughälfte (12 bzw. 13) nahe bei letzteren befindet.

3. Werkzeugmaschine nach Anspruch 1 oder 2, **dadurch gekennzeichnet**, dass der unbewegte Teil (8) des Kurvengetriebes eine bevorzugt gestellfeste Zugstrebe ist.

4. Werkzeugmaschine nach einem der vorstehenden Ansprüche, **dadurch gekennzeichnet**, dass die Führungseinrichtung (1) für die Werkzeuge sich zwischen diesen und den gesamten Kurvenbahnen erstreckt und sich die zweite(n) Rolle(n) (4a, 4b) dicht unter der Führungseinrichtung (1) bzw. einer Werkzeug-Aufspannplatte (8) befinden.

5. Werkzeugmaschine nach einem der vorstehenden Ansprüche, **dadurch gekennzeichnet**, dass sich die zweite(n) Rolle(n) (4a, 4b) bezogen auf die Achse der gesamten Kurvenbahnen in 90°-Stellung zu den ersten Rollen (6a, 6b) befinden.

6. Maschine nach einem der vorstehenden Ansprüche, **dadurch gekennzeichnet**, dass die zweiten Rollen (4a, 4b) im Durchmesser kleiner sind als die ersten Rollen (6a, 6b).

7. Maschine nach Anspruch 3 und 4, **dadurch gekennzeichnet**, dass die Aufspannplatte (8) die Zugstrebe ist, an welcher die Hebel (3a, 3b) schwenkbar gelagert sind.

8. Maschine nach Anspruch 3, 4 oder 7, **dadurch gekennzeichnet**, dass die Zugstrebe (8) waagerecht verläuft.

9. Maschine nach einem der Ansprüche 4 bis 8, **dadurch gekennzeichnet**, dass die zweiten Rollen (4a, 4b) der Aufspannplatte (8) unmittelbar benachbart sind.

10. Maschine nach einem der Ansprüche 4 bis 9, **dadurch gekennzeichnet**, dass die Aufspannplatte (8) eine Ausnehmung (18) hat, in welche die zweiten Rollen (4a, 4b) hineinragen.

11. Maschine nach einem der vorstehenden Ansprüche, **dadurch gekennzeichnet**, dass die Hebel (3a, 3b) in Lagerböcken (7) gelagert sind, welche parallel zur Achse der gesamten Kurvenbahnen, insbesondere längs der Aufspannplatte (8) verschiebbar sind.

12. Maschine nach einem der vorstehenden Ansprüche, **dadurch gekennzeichnet**, dass der die Rollen (6a, 6b, 4a, 4b) tragende Schenkel (33a, 33b) der Hebel (3a, 3b) in einen die erste Rolle (6a, 6b) tragenden Hauptschenkel (3a, 3b) und einen demgegenüber schwächeren, die zweite Rolle (4a, 4b) tragenden Nebenschenkel (35a, 35b) verzweigt ist.

13. Maschine nach Anspruch 12, **dadurch gekennzeichnet**, dass die Rollen (6a, 6b, 4a, 4b) den gesamten Kurvenbahnen durch Druck spielfrei anliegen.

14. Maschine nach einem der vorstehenden Ansprüche, **dadurch gekennzeichnet**, dass wenigstens die ersten Rollen (6a, 6b), vorzugsweise auch die zweiten Rollen (4a, 4b), beidseitig in ihrem Hebel (3a, 3b) gelagert sind.

15. Maschine nach einem der vorstehenden Ansprüche, **dadurch gekennzeichnet**, dass die gesamten Kurvenbahnen eine gemeinsame Achse (5) haben.

## Claims

1. Machine tool with tools for carrying out punching, cutting, embossing and shaping work, in particular for punching and shaping the lead-outs of integrated circuits,
having a frame (10),
having a cam gear, supported on the frame (10), for driving the tools along a guide device (1) and with two driving cam tracks located on parallel axes on the circumferential surface of one or more cam plates (21a, 21b, 22a, 22b),
having two two-arm levers (3a, 3b) pivotably supported on a stationary part (8) of the cam gear, the first arms (23a, 23b) of which two-arm levers (3a, 3b) being connected to a respective one of oppositely operating tool halves (12, 13) and their second arms (33a, 33b) respectively carrying a freely rotating roller (6a, 6b), of which one (6a) is in contact with said one driving cam track and the other (6b) is in contact with the other driving cam track and both rollers (6a, 6b) are located approximately diametrically with respect to the axis of the driving cam tracks (22a, 22b) and approximately parallel to the direction of motion of the tool (Z), and having further cam tracks disposed on the circumferential surface of the cam plate(s) for controlling the tool return,
characterised in that each driving cam track is associated with one of the further cam tracks and is rigidly connected to it and that the further cam tracks have a cam profile complementary to that on the driving cam track (on 22a, 22b) associated with it and are offset in the peripheral direction,
that the two levers (3a, 3b) respectively carry on their second arm (33a, 33b) a second, freely rotating roller (4a, 4b) which is in contact with the further cam track,
and that the second rollers (4a, 4b) are located close to a normal to the direction of motion Z of the tool halves (12, 13) and close to the latter, the normal passing through the axis of the cam tracks (on 21a, 21b; 22a, 22b).

2. Machine tool with tools for carrying out punching, cutting, embossing and/or shaping work, in particular for punching and shaping the lead-outs of integrated circuits,
having a frame (10)
having a cam gear, supported on the frame (10), for driving the tools along a guide device (1) and with a driving cam track on the circumferential surface of a cam plate (21a, 21b, 22a, 22b),
having a two-arm lever (3a or 3b) pivotably supported on a stationary part (8) of the cam gear, the first arm (23a or 23b) of which two-arm lever (3a or 3b) is connected to a movable tool half (12 or 13) working against a second tool half and which two-arm lever (3a, 3b) carries a freely rotating roller (6a or 6b) on its second arm (33a or 33b), which roller (6a or 6b) is in contact with the driving cam track and with a further cam track disposed on the circumferential surface of the cam plate for controlling the tool return,
characterised in that the driving cam track is associated with the further cam track and is rigidly connected to it and that the further cam track has a complementary cam profile to the driving cam track (on 22a or 22b) associated with it and is offset in the peripheral direction,
that the lever (3a or 3b) carries on its second arm (33a, 33b) a second, freely rotating roller (4a or 4b) which is in contact with the further cam track,
and that the second roller (4a or 4b) is located with its axis near to a normal to the direction of motion Z of the tool halves (12 and 13) and close to the latter, the normal passing through the axis of the cam tracks.

3. Machine tool according to Claim 1 or 2,
characterised in that the stationary part (8) of the cam drive is preferably a tie-rod fixed relative to the frame.

4. Machine tool according to one of the preceding claims,
characterised in that the guide device (1) for the tools extends between the latter and the total cam tracks and the second roller(s) (4a, 4b) is (are) located close below the guide device (1) or a tool clamping plate (8).

5. Machine tool according to one of the preceding claims, characterised in that the second roller(s) (4a, 4b) is (are) located on the axis of the total cam tracks at a 90° position relative to the first roller (6a, 6b).

6. Machine according to one of the preceding claims, characterised in that the second roller (4a, 4b) is smaller in diameter than the first roller (6a, 6b).

7. Machine according to Claims 3 and 4, characterised in that the clamping plate (8) is the tie-rod on which the levers (3a, 3b) are pivotably supported.

8. Machine according to Claim 3, 4 or 7, characterised in that the tie-rod (8) extends horizontally.

9. Machine according to one of Claims 4 to 8, characterised in that the second rollers (4a, 4b) are immediately adjacent to the clamping plate (8).

10. Machine according to one of Claims 4 to 9, characterised in that the clamping plate (8) has a recess (18) into which the second rollers (4a, 4b) protrude.

11. Machine according to one of the preceding claims, characterised in that the levers (3a, 3b) are supported in bearing blocks (7) which can be displaced parallel to the axis of the total cam tracks, in particular along the clamping plate (8).

12. Machine according to one of the preceding claims, characterised in that the arm (33a, 33b), of the lever (3a, 3b), carrying the rollers (6a, 6b, 4a, 4b) is branched into a main arm (3a, 3b) carrying the first roller (6a, 6b) and a second auxiliary arm (35a, 35b) which carries the second roller (4a, 4b) and is weaker than the first arm.

13. Machine according to Claim 12, characterised in that the rollers (6a, 6b, 4a, 4b) are in contact without clearance on the total cam tracks by means of pressure.

14. Machine according to one of the preceding claims, characterised in that at least the first rollers (6a, 6b), and preferably also the second rollers (4a, 4b), are supported in their lever (3a, 3b) at both ends.

15. Machine according to one of the preceding claims, characterised in that the total cam tracks have a common axis (5).

## Revendications

1. Machine-outil à outils pour réaliser des opérations d'estampage, de découpe, de frappe et de formage, en particulier pour l'estampage et le formage des pattes de connexion de circuits intégrés (IC),
comportant un bâti (10),
comportant une commande à cames, montée sur le bâti (10), pour l'entraînement des outils le long d'un dispositif de guidage (1) comportant deux pistes courbes d'entraînement disposées sur des axes parallèles, du côté frontal d'un ou de plusieurs disques à cames (21a, 21b, 22a, 22b),
comportant deux leviers (3a, 3b) à double bras, montés à pivotement sur une partie immobile (8) de la commande à cames, reliés chacun par leur premier bras (23a, 23b) à une de deux moitiés d'outil (12, 13) travaillant en opposition l'une à l'autre, et portant chacun sur leur second bras (33a, 33b) un galet (6a, 6b) à rotation libre dont l'un (6a) repose sur la première piste courbe d'entraînement (en 22a) et l'autre (6b) repose sur l'autre piste courbe d'entraînement, et les deux galets (6a, 6b) sont sensiblement diamétralement opposés par rapport à l'axe des pistes courbes d'entraînement (22a, 22b) et sont sensiblement parallèles à la direction (Z) de déplacement des outils,
et comportant d'autres pistes courbes disposées sur la face frontale du ou des disques à came, pour la commande du retour des outils,
caractérisée en ce que
chaque piste courbe d'entraînement est associée à une des autres pistes courbes et lui est reliée rigidement, et en ce que les autres pistes courbes possèdent un profil de courbe complémentaire de celui de la piste courbe d'entraînement (en 22a, 22b) qui leur est associée et sont décalées dans la direction périphérique,
en ce que les deux leviers (3a, 3b) portent chacun sur leur second bras (33a, 33b) encore un autre galet (4a, 4b) à rotation libre qui repose sur l'autre piste courbe, et en ce que l'axe des seconds galets (4a, 4b) est situé tout près d'une perpendiculaire, passant par l'axe des pistes courbes (en 21a, 21b; 22a, 22b), à la direction Z de déplacement des moitiés d'outil (12, 13), tout près de ces dernières.

2. Machine-outil à outils pour réaliser des opérations d'estampage, de découpe, de frappe et de formage, en particulier pour l'estampage et le formage des pattes de connexion de circuits intégrés (IC),
comportant un bâti (10),
comportant une commande à cames, montée sur le bâti (10), pour l'entraînement des outils le long d'un dispositif de guidage (1) comportant une piste courbe d'entraînement disposée du côté frontal d'un disque à cames (21a, 21b, 22a, 22b),
comportant un levier (3a ou 3b) à double bras, monté à pivotement sur une partie immobile (8) de la commande à cames, qui est relié par son premier bras (23a ou 23b) à une moitié d'outil (12 ou 13) mobile travaillant en opposition à une autre moitié d'outil, et portant sur son second bras (33a ou 33b) un galet (6a ou 6b) à rotation libre qui repose sur la piste courbe d'entraînement,
et comportant une autre piste courbe disposée sur la face frontale du disque à came, pour la commande du retour des outils,
caractérisée en ce que
la piste courbe d'entraînement est associée à l'autre piste courbe et lui est reliée rigidement, et en ce que l'autre piste courbe possède un profil de courbe complémentaire de celui de la piste courbe d'entraînement qui lui est associée et est décalée dans la direction périphérique,
en ce que le levier (3a, 3b) porte sur son second bras (33a ou 33b) encore un autre galet (4a ou 4b) à rotation libre qui repose sur l'autre piste courbe, et
en ce que l'axe du second galet (4a, 4b) est situé tout près d'une perpendiculaire, passant par l'axe des pistes courbes, à la direction Z de déplacement de la moitié d'outil (12 ou 13), tout près de cette dernière.

3. Machine-outil selon la revendication 1 ou 2, caractérisée en ce que la partie (8) immobile de la commande à cames est une entretoise, de préférence fixe sur le bâti.

4. Machine-outil selon l'une des revendications précédentes, caractérisée en ce que le dispositif de guidage (1) des outils s'étend entre ceux-ci et toutes les pistes courbes, et le ou les seconds galets (4a, 4b) sont situés étroitement en dessous du dispositif de guidage (1) ou d'un plateau (8) de serrage des outils.

5. Machine-outil selon l'une des revendications précédentes, caractérisée en ce que le ou les seconds galets (4a, 4b) sont situés par rapport aux premiers galets (6a, 6b) dans une position à 90° par rapport à l'axe de toutes les pistes courbes.

6. Machine selon l'une des revendications précédentes, caractérisée en ce que les seconds galets (4a, 4b) présentent un diamètre inférieur à celui des premiers galets (6a, 6b).

7. Machine selon la revendication 3 ou 4, caractérisée en ce que le plateau de serrage (8) constitue l'entretoise sur laquelle les leviers (3a, 3b) sont montés à pivotement.

8. Machine selon la revendication 3, 4 ou 7, caractérisée en ce que l'entretoise (8) s'étend horizontalement.

9. Machine selon l'une des revendications 4 à 8, caractérisée en ce que les seconds galets (4a, 4b) sont immédiatement voisins du plateau (8) de serrage.

10. Machine selon l'une des revendications 4 à 9, caractérisée en ce que le plateau (8) de serrage présente une découpe (18) dans laquelle débordent les seconds galets (4a, 4b).

11. Machine selon l'une des revendications précédentes, caractérisée en ce que les leviers (3a, 3b) sont montés dans des paliers (7) qui peuvent coulisser parallèlement à l'axe de toutes les pistes courbes, et en particulier le long du plateau (8) de serrage.

12. Machine selon l'une des revendications précédentes, caractérisée en ce que le bras (33a, 33b), portant les galets (6a, 6b, 4a, 4b), des leviers (3a, 3b) se ramifie en un bras principal (3a, 3b) portant les premiers galets (6a, 6b) et en un bras secondaire (35a, 35b), moins épais que le premier, et portant les seconds galets (4a, 4b).

13. Machine selon la revendication 12, caractérisée en ce que les galets (6a, 6b, 4a, 4b) de toutes les pistes courbes sont posés sans jeu sous l'action d'une pression.

14. Machine selon l'une des revendications précédentes, caractérisée en ce qu'au moins les premiers galets (6a, 6b), et de préférence également les seconds galets (4a, 4b), sont montés par les deux côtés dans leur levier (3a, 3b).

15. Machine selon l'une des revendications précédentes, caractérisée en ce que toutes les pistes courbes possèdent un axe commun.
